# EUROPEAN PATENT SPECIFICATION

(11) **EP 1 974 247 B1**
(45) Date of publication and mention of the grant of the patent: **10.11.2010**
(21) Application number: 07702990.8
(22) Date of filing: 17.01.2007
(51) Int. Cl.: G05F 1/46, G05F 1/56, G08B 29/28, G01R 31/02

(54) **SENSING AN OPERATING STATE OF A SYSTEM**
ERFASSEN EINES BETRIEBSZUSTANDS EINES SYSTEMS
DÉTECTION DE L'ÉTAT OPÉRATIONNEL D'UN SYSTÈME

(30) Priority: 18.01.2006 GB 0601074
(43) Date of publication of application: 01.10.2008
(73) Proprietor: Bombardier Transportation GmbH, 10785 Berlin (DE)
(72) Inventor: GUMMERSON, Paul, S-722 44 Västeras (SE); MALIS, Ingemar, S-73050 Skultuna (SE)
(74) Representative: Patentanwälte Bressel und Partner
(86) International application number: PCT/EP2007/000583
(87) International publication number: WO 2007/082778

(56) References cited:
- EP-A2- 0 522 244
- DE-A1- 4 220 778
- US-A- 2 917 700
- US-A- 3 909 664

## Description

The present invention relates to a method and a device of/for sensing an operating state of a component, in particular a digital signal representing the operating state of an electric or electronic component, for example a relay. More particularly, the invention relates to the operation and/or control of the component or of a system including the component. The component and the sensing device may be part of a railroad vehicle.

EP 0 522 244 A2 describes a method and apparatus for transmitting signals on a transmission line having a plurality of terminals in a multidrop fashion. A DC current flows through the transmission line. Each of the terminals can draw a portion of the DC current. A signal is transmitted on the transmission line by varying the portions of the DC current drawn by the terminals. When the signal is not being transmitted the total amount of the DC current drawn by the terminals from the transmission line is maintained at a value smaller than an average amount of the DC current drawn by the terminals from the transmission line when the signal is being transmitted.

DE 4220778 A1 describes a digital input device using a load circuit which is sized to ensure that, when the contact-energising voltage is at its lowest forseen magnitude (e.g. 160V), the current is greater that that (e.g. 6mA) required to maintain the contacts free of oxidisation.

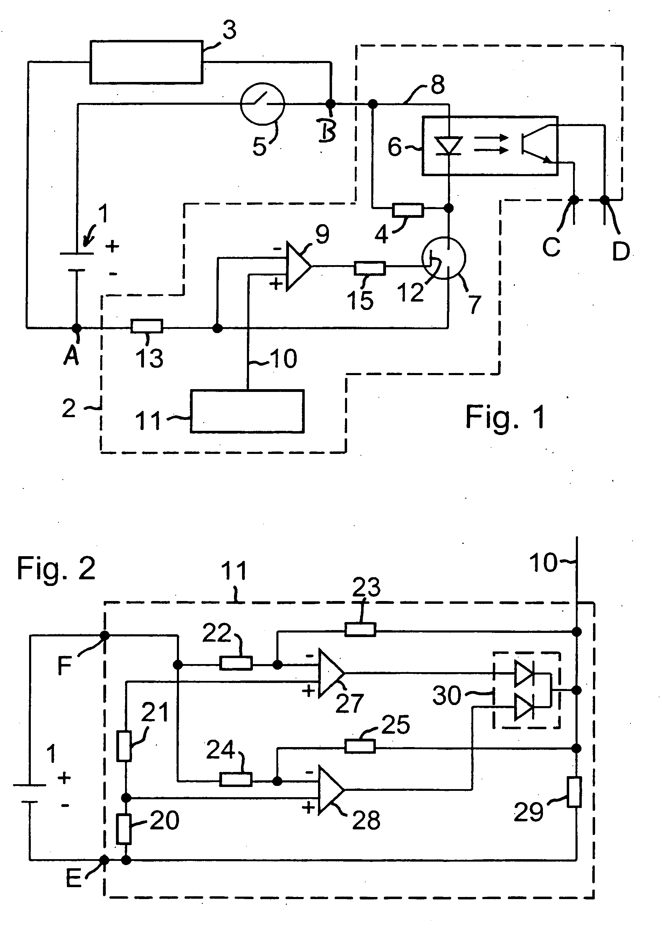

A sensing unit which is adapted to produce a digital signal, depending on whether an electric current is carried by a line or not, is known from the "SCXI-1182, User Manual", March 1994 edition, part number 320572-01, published in the internet by National Instruments Corporation, 11500 N Mopac Expwy, Austin, TX 78759-3504, USA, http://www,ni.com/pdf/manuals/320572,pdf. According to Figure 2-3 of the user manual, a logic "low" signal is produced, if a switch is closed, and a logic "high" signal is produced, if the switch is open. A different expression for such a sensing unit is "digital input module", since it produces a digital signal which can be used as input to a data bus or computer system. Another expression may be "signal generating unit".

In the example mentioned before, the switch is used to switch on and off a load. Alternatively, the switch may be a switch which comprises auxiliary contacts for detecting an operation state of any component or system. The auxiliary contacts remain open until a specific operation state is reached. Then, the auxiliary contacts are closed (contact each other electrically) and the sensing unit produces a corresponding digital signal.

Contacts of the switch may be subject to debris or oxidation, if the electric current in the ON state of the switch is too small. For a given voltage of an electric power source, for example 10 V, the sensing unit can be designed to let pass a sufficient electric current, e.g. by choosing an appropriate Ohmic resistance. However, the power which can be dissipated into heat by resistive components of the sensing unit is limited to a maximum. In practice, the Ohmic resistance as well as the construction of the sensing unit can be adapted to match the competing requirements (current higher than minimum, power lower than maximum) mentioned before. However, the effort for development, production and maintenance of individually designed sensing units is high.

It is an object of the present invention to provide a universal digital input device, of the type mentioned above.

The attached claims define the scope of protection. It is proposed to control the size of the electric current carried by an electric line of the sensing device. Preferably, the size of the electric current is controlled in such a manner that the electric power, which is dissipated into heat due to any Ohmic resistance in the line, is approximately constant. The term "constant" refers to different voltages which may drive the electric current in the line. On one hand, said voltage may fluctuate during operation of the sensing device. On the other hand, said voltage differs for different arrangements, wherein each of the different arrangements comprises a combination of the sensing device with a different source of voltage, e.g. having a nominal voltage of 16.8 V in one arrangement and having a nominal voltage of 137.5 V in another arrangement.

Due to the approximately constant power, the same sensing device can be used in a wide range of applications. There is no need to adapt the sensing device or the components of the line. In particular, the arrangement can be designed such that the electric current in the line has the same size as for conventional sensing units, if the maximum possible voltage is used to drive the current. The term "maximum possible" refers to all possible arrangements and/or operating states of the sensing device. A voltage is no more possible, if it exceeds the range of admissible voltages of the sensing device. For example, the maximum possible voltage may be 140 V. However, if the voltage is smaller than the maximum possible voltage, the electric current in the line is controlled to be higher than for the maximum possible voltage. Experiments have shown that this prevents the contacts of any switch, which is connected in series to the line, from being affected by debris or oxidation. This in many cases eliminates the need for expensive, low corrosive, high performance contacts for example gold plated and instead allows for the use of 'standard', cost effiecient contacts.

There are different ways of sensing the operating state. The signal generating unit may sense the current or, alternatively, may sense a voltage. For example, a first type of digital signal (e.g. logic "0") is generated, if the voltage is smaller than a threshold value, and a second type of digital signal (e.g. logic "1") is generated, if the voltage is greater than a threshold value.

According to another aspect of the present invention, a method is proposed of sensing an operating state of an electric and/or electronic component, in particular of a relay. The method comprises:
- producing a signal representing the operating state, in particular producing a digital signal depending on whether an electric voltage exceeds a thresold value or not; and
- controlling the size of an electric current, wherein the current is flowing at least in a particular operating state of the system or component, by increasing the size of the electric current if the current is driven by a smaller voltage and vice versa.

For all embodiments of the invention, it is preferred that the concept of increasing the size of the electric current, if the current is driven by a smaller voltage, and vice versa applies to all voltages which are smaller than a predetermined voltage (in particular the maximum possible or admissible voltage). In other words, the current is increased with decreasing voltages (or when the voltage is smaller) and this is valid until the minimum possible voltage is reached. The minimum possible (or admissible) voltage may be, for example, given by the operating state of the sensing device in which a controllable electric valve (which is used to control the size of the current) is fully open.

More generally speaking, it is possible
- to increase the size of the electric current if the current is driven by a smaller voltage and vice versa, when the voltage is in a range near a minimum possible or admissible voltage (according to the attached claims) and/or
- to increase the size of the electric current if the current is driven by a smaller voltage and vice versa under any operating conditions (in particular within the whole range of voltages which are admissible for a specific sensing device or arrangement), in which a control unit is able to control the size of the current.

In a particular application of the method or of the sensing device, a switch (in particular a relay or a contactor) may be provided. If the switch is ON, a line of the control unit carries the electric current. This corresponds to the "particular operating statue". If the switch is OFF, no current is carried by the line. Accordingly, the sensing device senses if the switch is ON or OFF.

If the switch is OFF, the process of controlling the size of the electric current can be interrupted, since there is no current to be controlled. However, the control unit preferably remains active and produces any control signal (such as a voltage) which is used to control an actuator of the control unit in times when the line carries the electric current.

In particular, the switch may be part of a relay, wherein the contacts of the switch may be electrically insulated from the main contacts of the relay. The relay may be used in a railroad train or railroad vehicle, for example as a line circuit breaker of a main electric circuit of the train, as a switch of a heating/ventilation system of the train, as a switch for a railroad vehicle lighting system, as a switch within a railroad train door interlock circuitry (e.g. in order to produce a signal to close all doors when the switch is ON), as a switch within electric lines of the train (e.g. to produce signals for motoring, braking, emergency braking, forward/reverse movement direction of the train. Furthermore, the switch can be combined with a push button (e.g. for manually operating doors, heating, lighting etc...).

More generally speaking, the switch can be combined with a component or system comprising two operation states. When a first operation state is reached, the switch is automatically switched on. When a second operation state is reached, the switch is automatically switched off. Thus, it is possible to detect the operation states by evaluating the digital signal which is produced by the sensing device.

Furthermore, a sensing device is proposed for sensing an operating state of an electric or electronic component. The sensing device may be operated according to the method of the present invention. The proposed sensing device comprises:
- a signal generating unit which is adapted to produce a signal representing the operating state, in particular to produce a digital signal depending on whether an electric voltage exceeds a threshold value or not; and
- a control unit which is adapted to control the size of an electric cur-rent, wherein the current is carried by a line of the control unit at least in a particular operating state of the system or component and wherein the control unit increases the size of the electric current if the current is driven by a smaller voltage and vice versa.

The term "size" of the electric current refers to a stable (non-transient) or nearly stable state at the end of the process of switching on or off the current in the line (or of a process of varying the voltage).

In a specific embodiment of the sensing device, the control unit comprises a controllable electric valve, which is controlled to adjust the electric current carried by the line depending on the voltage.

The valve may be connected in parallel and/or in series to the signal generating unit. If the valve is connected in parallel to the signal generating unit, the signal generating unit may comprise a comparator for comparing the voltage with a threshold voltage. If the threshold voltage is exceeded, the signal generating unit produces a first signal (e.g. logic "1"). If the threshold voltage is not exceeded, the signal generating unit produces a second signal (e.g. logic "0"). For example, if the system or component to be monitored is a switch or comprises a switch and if the current is switched on or off according to the switching state of the switch, the first signal will be produced when the switch is switched on and the second signal will be produced when the switch is switched off.

In particular, the electric current is controlled by controlling the valve in the line. The valve may comprise a control electrode and a degree how much the valve is opened or closed (i.e. the size of the current passing the valve) is controlled using the control electrode.

Preferably, the control electrode is connected to and controlled by an operational amplifier. The valve may be a transistor, in particular an IGBT (Insulated Gate Bipolar transistor) or a MOSFET (Metal Oxide Field Effect Transistor) for example. The operational amplifier may preferably be part of a regulator circuit and a resistor can be connected in between an output of the operational amplifier and the control electrode, in order to dampen or in order to avoid oscillations of the regulator circuit, i.e. oscillations of the current in the line.

In a specific embodiment, the control unit comprises a control circuitry which comprises contacts to be contacted with a voltage source. Said voltage source is the voltage source which produces the voltage that drives the electric current in the line of the sensing device. The control circuitry is adapted to produce a control signal which causes an actuator, in particular the valve, to increase the size of the electric current if the current is driven by a smaller voltage and vice versa. Such a control circuitry can easily be implemented in hardware.

In order to keep the power constant, the current should be proportional to the inverse of the voltage. However, this is difficult to implement in practice. Therefore, according to a preferred embodiment, the control circuitry comprises at least one control element which is adapted to linearly increase the size of the electric current when the electric current is driven by a linearly decreased voltage and vice versa. This linear control behaviour of the control element is applied at least within a defined range of the voltage. However, a different control behaviour or control strategy may be used outside of boundaries of the defined range. For example, the control circuitry comprises two or more of the control elements, wherein each of the control elements is adapted to produce a different control signal to control the size of the electric current and wherein the control unit is adapted to use a selected one of the control signals depending on the range of the voltage. As a result, the desired proportionality of the current to the inverse of the voltage can be an approximated.

Preferably, the sensing unit and the control unit are integrated in a single module.

This means that there is a universal (single-piece) module which can be used in any arrangement, in particular in combination with any voltage source. For example, the single module comprises joint external contacts for electrically connecting the sensing unit and the control unit to other parts or components, such as a battery and the relay mentioned above.

According to another aspect of the invention, an arrangement comprises the sensing device and further comprises a switch for switching on and off the line of the sensing device.

An example of the present invention will be described in the following with reference to the accompanying drawing. The figures of the drawing show:
- Fig. 1: schematically a circuit diagram of a first sensing device which is con- nected to a switch, to a load and to a digital system,
- Fig. 2: a preferred embodiment of a control circuitry which is part of the sens- ing device shown in figure 1,
- Fig. 3: shows an x-y-diagram,
- Fig. 4: an arrangement comprising a second sensing device having a control unit which is connected in parallel to the signal generating unit and
- Fig. 5: a relay in an electric line having auxiliary contacts.

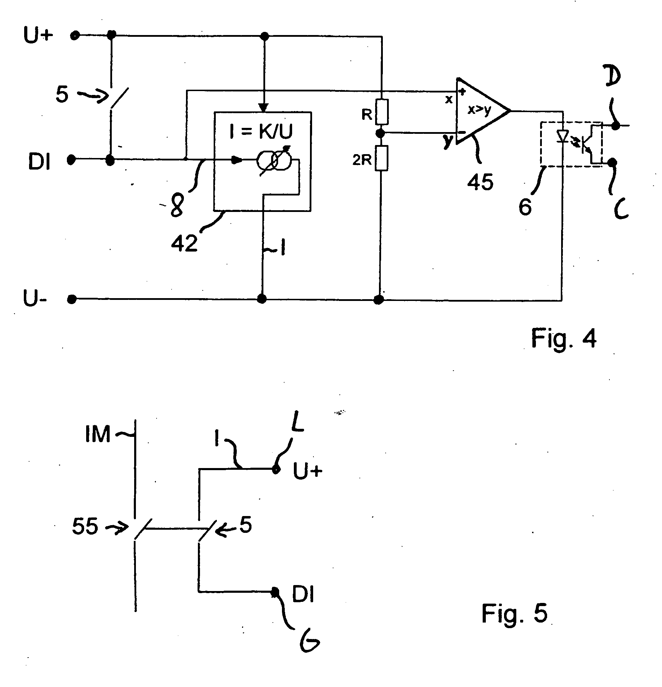

Same reference numerals (e.g. "6" in Fig. 1 and Fig. 4) are used for identical or similar components in different embodiments.

Elements of the sensing device shown in figure 1 and figure 2 can be replaced by elements described above. For example, the MOSFET 7 can be replaced by a different type of valve.

Figures 1 and 2 are meant to be schematic drawings. In practice, further electric connections and/or further elements of the circuit may be provided.

Referring to figure 1, reference numeral 2 denotes a preferred embodiment of a sensing device according to the present invention. Elements of the sensing device 2 are enclosed by a dashed line. The sensing device 2 comprises contacts A, B, C, D in order to electrically connect the device to an electric circuit comprising a voltage source 1, such as a battery, and further comprising a switch 5 and a load 3. The voltage source 1, the switch 5 and the load 3 are connected in series so that the voltage source 1 drives a current from a plus pole to the load and from the load to a minus pole, if the switch 5 is switched on.

However, in a modified arrangement, there is no load 3 connected to the contacts A, B. In other words: The only load of the voltage source 1, which is switched on and off by switch 5, is the sensing device 2. This is the case, for example, if the contacts of the switch 5 are auxiliary contact of a component (e.g. relay 55, Fig. 5). The main function of the component can be a switching function but, more generally, any function which has two operation states. In a first operation state the switch 5 is switched on and in a second operation state, the switch 5 is switched off, thereby enabling that the two operation state can be sensed by a sensing device.

The sensing device 2 comprises an internal line 8 which electrically connects the contacts A, B that are used to connect the sensing device to the electric circuit 1, 3, 5. A sensing unit 6, an IGBT 7 and a resistor 13 are connected in series on the line 8. The sensing unit 6 comprises an opto-electric coupling device. A resistor 4 is connected in parallel to the diode on the primary side of the device 4.

If the line 8 carries an electric current, a corresponding logic signal (for example "high") is generated on a secondary side of the sensing unit 6 and the signal is transferred to a digital system 4 via contacts C, D. If switch 5 is OFF the line 8 does not carry an electric current and a corresponding logic signal (for example "low") is generated on the secondary side of the sensing unit 6. A digital system may be connected to contacts C, D which comprise a data bus and a computer, for example. In particular, the digital system may be part of a monitoring system and/or control system of a railroad vehicle. If the digital system knows the signal produced by the sensing unit 6 when the maximum possible voltage of power source 1 is applied to the sensing device 2, it can reliably produced a digital signal from the output of the sensing unit 6 representing the switching state of switch 5.

A control electrode 12 of MOSFET 7 is connected to an output of an operational amplifier 9 via a resistor 15. An inverting input (marked with "-") of the amplifier 9 is connected to the line 8. A non-inverting input (marked with "+") of the amplifier 9 is connected to a control circuitry 11 via a connection 10.

The preferred embodiment of the control circuitry 11 (figure 2) is connected (via contact F) to the plus pole and (via contact E) to the minus pole of the voltage source as well. The plus pole is connected to an inverting input (marked with "-") of a second operational amplifier 27 via a resistor 22. Furthermore, the plus pole is connected to an inverting input (marked with "-") of a third operational amplifier 28 via a resistor 24. The minus pole is connected to a non-inverting input (marked with "+") of the second operational amplifier 27 via a series connection of two resistors 20, 21. Furthermore, the minus pole is connected to a non-inverting input (marked with "+") of the third operational amplifier 28 via the resistor 20. In addition, the inverting input of the second operational amplifier 27 is connected to the connection 10 via a resistor 23 and the inverting input of the third operational amplifier 28 is connected to the connection 10 via a resistor 25. The connection 10 is connected to the minus pole via a resistor 29. The output of the second amplifier 27 is connected to a first input of a diode device 30. The output of the third amplifier 28 is connected to a second input of the diode device 30. Each of the inputs of the diode device 30 is connected to the output of the diode device 30 via one diode.

The sensing device 2 with integrated control unit (comprising elements 7, 9, 10, 11, 13, 15) operates as follows: the amplifier 9 regulates the voltage at the gate 12 of MOSFET 7 so that the voltage drop across the resistor 13 is (nearly) equal to the voltage at the non-inverting input of the amplifier 9. Thus, the voltage (electric potential of the connection 10 with reference to the minus pole of the voltage source 1, i.e. the voltage across the resistor 29) which is produced by the control circuitry 11 controls the size of the current carried by the line 8.

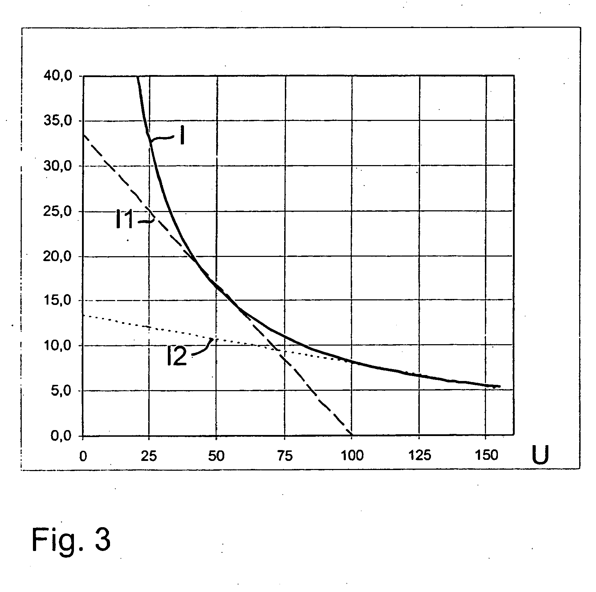

Figure 3 shows an x-y-diagram, wherein the voltage U (in Volts) of the voltage source 1 forms the x-axis. The units on the y-axis are arbitrary units. Three functions are represented in the diagram: 1.) The current that would be carried by the line 8 in an ideal situation of constant power (or a corresponding ideal control voltage produced by circuitry 11), 2.) A first real control voltage function which is generated by the second operational amplifier 27 of circuitry 11; and 3. a second real control voltage function which is generated by the third operational amplifier 28 of circuitry 11. The real control voltage functions are (straight) lines, i.e. the control voltage drops linearly with increasing source voltage U. These (straight) linear functions are produced, since the output of each of the amplifiers 27, 28 is fed back to the respective inverting input and, thus, the amplifiers are configured as inverting amplifiers (as described above with reference to figure 2). Details of configuring operational amplifiers by choosing resistors having appropriate resistances are described in any standard book of electronic devices, such as "Electronic Circuits - Design and Applications", U. Tietze et al., 2nd ed., 1993, Springer-Verlag, New York, ISBN: 0-387-50608-X.

As mentioned earlier, the control voltage at the connection 10 would ideally be proportional to the inverse of the source voltage U (first function). However, this is difficult to achieve in practice, using hardware. Thus, the linear and control voltages are generated by operational amplifiers 27, 28. Diode device 30 receives the output of both amplifiers 27, 28 at its inputs and outputs the higher voltage of the two control voltages I1, I2. Referring to the example shown in figure 3, I1 comprises the higher voltage up two source voltages of 72 V and I2 comprises the higher voltage from source voltages of 72 V and higher.

It is preferred (as shown in the example) that the lines of the real control voltage functions are tangents of the ideal control voltage. As a result, a good approximation of the ideal situation is achieved by the real control functions.

The sensing device 2 shown in figure 1 may be operated as follows:
If switch 5 is in the OFF state, the control voltage in the connection 10 is still present and causes valve 7 to be open. Then, an event may happen so that switch 5 is switched on. A current starts flowing through the line 8. Due to the resulting voltage drop across resistor 13, the amplifier 9 starts a process of gradually closing the valve 7. Depending on the resistance of resistor 15, the process continuously reaches the final (stable) state in which the current through the line is constant, or, the current may be reduced to a value which is smaller than in the final state and the valve will be slightly opened again. The final state (i.e. the size of the current) solely depends (for a given embodiment of the circuitry) on the control voltage in the connection 10.

Figure 4 shows the basic concept of a second embodiment of a sensing device. This embodiment illustrates that the signal generating unit and the control unit for controlling the current can be arranged in parallel to each other with respect to the voltage which drives the current.

The contacts marked with U+ and U- are connected to a voltage source. A voltage divider comprising a series connection of two resistors R, 2R (which means for this specific embodiment that the resistance of resistor 2R is twice the resistance of resistor R) is connected between the two contacts. The line element in between the two resistors R, 2R is connected with a first input (marked with y and "-") of a voltage comparator 45. A second input (marked with x and "+") of the comparator 45 is connected with a contact or line DI which can directly be connected to contact U+, if a switch 5 is closed. If switch 5 is open, the electric potential of contact or line DI is floating.

Switch 5 may be a switch which is provided to connect or disconnect auxiliary contacts G, L (Fig. 5) depending on the switching state of a relay 55 or of another component. The main switch of the relay 55 is coupled to the switch 5 so that the switch 5 is open when the main switch is open and vice versa. The main switch is, for example, arranged in a main electric line of a railroad vehicle for distributing electric energy within the vehicle.

Furthermore, DI is connected by a line 8 to contact U-, via a control unit 42. The control unit 42 is adapted to approximately keep constant the electric power K dissipated with in the control unit 42 or dissipated in line 8 which connects U+ and U-. The power K is equal to the product of the current I which is carried by the line and the voltage U of the voltage source. An arrow from plus potential U+ of the voltage source to the control unit 42 symbolises that the control unit 42 may use the plus potential U+ for the control process. In particular, the control unit 42 may be designed as shown in figures 1 and 2, wherein the opto-coupling element 6 and the resistor 4 can be omitted.

A switch 5 is closed, the plus potential U+ is applied to the second input of the comparator 45. Since the plus potential U+ is higher than the divided voltage at the first input of the comparator 45 (which is in the specific embodiment 66 % of U+, but may be any other voltage between U- and U+, according to the dimension of the voltage divider), comparator 45 outputs a current which is flowing through the primary side of the opto-coupling device 6 to U-. Consequently, device 6 produces a corresponding signal (e.g. "high") on its secondary side.

If switch 5 is open, the potential at DI and at the second input of the comparator 45 is floating and no current (or only a small current) is flowing from the output of the comparator 45 through the primary side of device 6 to U-. Consequently, device 6 produces a corresponding signal (e.g. "low") on its secondary side.

The arrangement shown in figure 4 may be integrated in a single component (package and/or housing).

## Claims

1. A digital input device (2) for producing a digital signal as an input to a data bus or to a computer system, wherein the digital signal is produced depending on a sensing result whether a switch (5) in an electric line (8) is closed - and therefore an electric current is carried by the electric line (8) - or if the switch is open, thereby sensing an operating state of a system or component (5), in particular of an electric or electronic component, wherein the digital input device (2) is operable using a voltage in a range of admissible voltages, wherein the voltage drives the electric current in the electric line (8), wherein the range of admissible voltages is limited by a maximum voltage at which
a first electric current flows in the electric line (8) and,
wherein the digital input device (2) comprises:
- a signal generating unit (6, 45) which is adapted to produce the digital
signal representing the operating state;
**characterized by**
- a control unit (42) which is adapted to control the size of the electric current, wherein the eletric line (8) extends within the control unit (42),
wherein the control unit (42) is adapted to
prevent contacts of the switch (5) from being affected by debris or oxidation by
- if the voltage is smaller than the maximum, voltage,
- controlling the electric current in the electric line (8) such that the electric current is higher than the first electric current.

2. The digital input device of the preceding claim, wherein the signal generating unit (6) and the control unit (42) are integrated in a single module.

3. The digital input device of the preceding claim, wherein the single module comprises joint external contacts (A, B) for electrically connecting the signal generating unit (6, 45) and the control unit (42) to other parts or components.

4. The digital input device of one of the preceding claims, wherein the digital input device comprises a resistor (13) in the electric line (8) so that electric energy is dissipated into heat.

5. The digital input device of one of the preceding claims, wherein the control unit (7, 9, 10, 11, 13, 15) comprises a transistor (7) which is controlled to adjust the electric current carried by the electric line (8) depending on the voltage.

6. The digital input device of the preceding claim, wherein the transistor (7) is connected in series to the signal generating unit (6).

7. The digital input device of claim 6, wherein the transistor is connected in parallel to a comparator (45) for comparing the voltage with a threshold voltage.

8. The digital input device of one of the preceding claims, wherein the control unit (7, 9, 10, 11, 13, 15) comprises a control circuitry (11) which comprises contacts (E, F) to be contacted with a voltage source (1), wherein the voltage source (1) produces the voltage (U) which drives the electric current and wherein the control circuitry (11) is adapted to produce a control signal (I1, I2) which causes the size of the electric current to be increased if the current is driven by a smaller voltage and vice versa.

9. The digital input device of the preceding claim, wherein the control circuitry (11) comprises at least one control element (27, 28) which is adapted to linearly increase the size of the electric current when the electric current is driven by a linearly decreased voltage and vice versa.

10. The digital input device of the preceding claim, wherein the control circuitry (11) comprises two or more of the control elements (27, 28), wherein each of the control elements (27, 28) is adapted to produce a different control signal to control the size of the electric current and wherein the control unit (7, 9, 10, 11, 13, 15) is adapted to use a selected one of the control signals depending on the range of the voltage.

11. An arrangement comprising the digital input device (2) of one of the preceding claims and further comprising the switch (5) for switching on and off the electric line (8).

12. A method of producing a digital signal, wherein the digital signal is produced depending on a sensing result whether a switch (5) in an electric line (8) is closed - and therefore an electric current is carried by the line - or if the switch is open, thereby sensing an operating state of a system or component (5), in particular of an electric or electronic component, wherein the electric line (8) is operable using a voltage in a range of admissible voltages, wherein the voltage drives the electric current in the electric line (8), wherein the range of admissible voltages is limited by a maximum voltage at which a first electric current flows in the electric line (8) and wherein the method comprises:
- producing the digital signal representing the operating state;
**characterized by**
preventing contacts of the switch (5) from being affected by debris or oxidation by - if the voltage is smaller than the maximum voltage - controlling the electric current in the electric line (8) such that the electric current is higher than the first electric current.

13. The method of claim 12, wherein the electric current is controlled by controlling a transistor (7) in the electric line (8) carrying the current.

14. The method of claim 12 or 13, wherein the size of the electric current is linearly increased when the electric current is driven by a linearly decreased voltage and vice versa.

15. The method of claim 14, wherein the size of the electric current is linearly decreased according to a first linear function (I1) when the electric current is driven by a linearly increased voltage and vice versa in a first range of the voltage, wherein the size of the electric current is linearly decreased according to a second linear function (I2) when the electric current is driven by a linearly increased voltage and vice versa in a second range of the voltage, and wherein the first linear function (I1) and the second linear function (I2) comprise different slopes and different offsets at voltage zero, thereby approximating a hyperbolic decrease of the electric current with increasing voltage.

## Patentansprüche

1. Digitale Eingabeeinrichtung (2) zum Erzeugen eines digitalen Signals als eine Eingabe für einen Datenbus oder ein Computersystem, wobei das digitale Signal abhängig von einem Messergebnis erzeugt wird, ob ein Schalter (5) in einer elektrischen Leitung (8) geschlossen ist - und daher ein elektrischer Strom von der elektrischen Leitung (8) geführt wird - oder ob der Schalter offen ist, wodurch ein Betriebszustand eines Systems oder einer Komponente (5) gemessen wird, insbesondere einer elektrischen oder elektronischen Komponente, wobei die digitale Eingabeeinrichtung (2) ausgestaltet ist, eine Spannung in einem Bereich von zulässigen Spannungen zu verwenden, wobei die Spannung den elektrischen Strom in der elektrischen Leitung (8) treibt, wobei der Bereich von zulässigen Spannungen durch eine maximale Spannung, bei der ein erster elektrischer Strom in der elektrischen Leitung (8) fließt, begrenzt wird und wobei die digitale Eingabeeinrichtung (2) aufweist:
- eine Signalerzeugungseinheit (6, 45), die ausgestaltet ist, das digitale Signal,
welches den Betriebszustand repräsentiert, zu erzeugen;
**gekennzeichnet durch**
- eine Steuereinheit, die ausgestaltet ist, die Größe des elektrischen Stroms zu steuern, wobei die elektrische Leitung (8) sich innerhalb der Steuereinheit (42) erstreckt,
wobei die Steuereinheit (42) ausgestaltet ist, Kontakte des Schalters (5) vor Auswirkungen von Ablagerungen oder Oxidation zu bewahren, **durch** - wenn die Spannung kleiner ist als die maximale Spannung - Steuern des elektrischen Stroms in der Leitung (8), so dass der elektrische Strom größer ist als der erste elektrische Strom.

2. Digitale Eingabeeinrichtung nach dem vorhergehenden Anspruch, wobei die Signalerzeugungseinheit (6) und die Steuereinheit (42) in ein einziges Modul integriert sind.

3. Digitale Eingabeeinrichtung nach dem vorhergehenden Anspruch, wobei das einzige Modul gemeinsame externe Kontakte (A, B) zum elektrischen Kontaktieren der Signalerzeugungseinheit (6, 45) und der Steuereinheit (42) mit anderen Teilen oder Komponenten aufweist.

4. Digitale Eingabeeinrichtung nach einem der vorhergehenden Ansprüche, wobei die digitale Eingabeeinrichtung einen Widerstand (13) in der elektrischen Leitung (8) aufweist, so dass elektrische Energie in Wärme dissipiert wird.

5. Digitale Eingabeeinrichtung nach einem der vorhergehenden Ansprüche, wobei die Steuereinheit (7, 9, 10, 11, 13, 15) einen Transistor (7) aufweist, der derart gesteuert wird, dass der elektrische Strom, der durch die elektrische Leitung (8) fließt, abhängig von der Spannung eingestellt wird.

6. Digitale Eingabeeinrichtung nach dem vorhergehenden Anspruch, wobei der Transistor (7) in Serie zu der Signalerzeugungseinheit (6) geschaltet ist.

7. Digitale Eingabeeinrichtung nach Anspruch 6, wobei der Transistor parallel zu einem Komparator (45) zum Vergleichen der Spannung mit einem Spannungsgrenzwert geschaltet ist.

8. Digitale Eingabeeinrichtung nach einem der vorgehenden Ansprüche, wobei die Steuereinheit (7, 9, 10, 11, 13, 15) eine Steuerschaltung (11) aufweist, die Kontakte (E, F) aufweist, die mit einer Spannungsquelle (1) zu kontaktieren sind, wobei die Spannungsquelle (1) die Spannung (U) erzeugt, welche den elektrischen Strom treibt, und wobei die Steuerschaltung (11) ausgestaltet ist, ein Steuersignal (I1, I2) zu erzeugen, das die Größe des elektrischen Stroms dazu bringt anzuwachsen, wenn der Strom durch eine kleinere Spannung getrieben wird, und umgekehrt.

9. Digitale Eingabeeinrichtung nach dem vorhergehenden Anspruch, wobei die Steuerschaltung (11) zumindest ein Steuerelement (27, 28) aufweist, welches ausgestaltet ist, die Größe des elektrischen Stroms linear ansteigen zu lassen, wenn der elektrische Strom durch eine linear abfallende Spannung getrieben wird, und umgekehrt.

10. Digitale Eingabeeinrichtung nach dem vorhergehenden Anspruch, wobei die Steuerschaltung (11) zwei oder mehr der Steuerelemente (27, 28) aufweist, wobei jedes der Steuerelemente (27, 28) ausgestaltet ist, ein verschiedenes Steuersignal zu erzeugen, um die Größe des elektrischen Stroms zu steuern, und wobei die Steuereinheit (7, 9, 10, 11, 13, 15) ausgestaltet ist, ein ausgewähltes der Steuersignale zu nutzen, abhängig von dem Bereich der Spannung.

11. Anordnung, aufweisend die digitale Eingabeeinrichtung (2) nach einem der vorhergehenden Ansprüche und weiterhin aufweisend den Schalter (5) zum Ein- und Ausschalten der elektrischen Leitung (8).

12. Verfahren zum Erzeugen eines digitalen Signals, wobei das digitale Signal abhängig von einem Messresultat, ob ein Schalter (5) in einer elektrischen Leitung (8) geschlossen ist- und daher ein elektrischer Strom von der Leitung geführt wird - oder ob der Schalter offen ist, wodurch ein Betriebszustand eines Systems oder einer Komponente (5), insbesondere einer elektrischen oder elektronischen Komponente, gemessen wird, erzeugt wird, wobei die elektrische Leitung (8) ausgestaltet ist, eine Spannung in einem Bereich von zulässigen Spannungen zu nutzen, wobei die Spannung den elektrischen Strom in der elektrischen Leitung (8) treibt, wobei der Bereich von zulässigen Spannungen durch eine maximale Spannung begrenzt wird, bei der ein erster elektrischer Strom in der elektrischen Leitung (8) fließt und wobei das Verfahren aufweist:
- Erzeugen des digitalen Signals, das den Betriebszustand repräsentiert; **gekennzeichnet durch**
- Verhindern, dass Kontakte des Schalters (5) **durch** Ablagerungen oder Oxidation beeinflusst werden, indem - wenn die Spannung kleiner ist als die maximale Spannung - der elektrische Strom in der elektrischen Leitung (8) derart gesteuert wird, dass der elektrische Strom größer ist als der erste elektrische Strom.

13. Verfahren nach Anspruch 12, wobei der elektrische Strom durch Steuern eines Transistors (7) in der elektrischen Leitung (8), die den Strom führt, gesteuert wird.

14. Verfahren nach Anspruch 12 oder 13, wobei die Größe des elektrischen Stroms linear anwächst, wenn der elektrische Strom durch eine linear abfallende Spannung getrieben wird, oder umgekehrt.

15. Verfahren nach Anspruch 14, wobei die Größe des elektrischen Stroms linear abfällt, entsprechend einer ersten linearen Funktion (I1), wenn der elektrische Strom durch eine linear anwachsende Spannung getrieben wird, und umgekehrt, in einem ersten Bereich der Spannung, wobei die Größe des elektrischen Stroms linear abfällt, entsprechend einer zweiten linearen Funktion (I2), wenn der elektrische Strom durch eine linear ansteigende Spannung getrieben wird, und umgekehrt, in einem zweiten Bereich der Spannung, und wobei die erste lineare Funktion (I1) und die zweite lineare Funktion (I2) unterschiedliche Steigungen und unterschiedliche Y-Achsenabschnitte bei Spannung null aufweisen, wodurch ein hyperbolisches Abfallen des elektrischen Stroms mit ansteigender Spannung approximiert wird.

## Revendications

1. Dispositif d'entrée numérique (2) pour produire un signal numérique en tant qu'entrée pour un bus de données ou pour un système informatique, dans lequel le signal numérique est produit suivant un résultat de détection indiquant si un commutateur (5) dans une ligne électrique (8) est fermé - et donc un courant électrique est transporté par la ligne électrique (8) - ou si le commutateur est ouvert, détectant ainsi un état de fonctionnement d'un système ou composant (5), en particulier d'un composant électrique ou électronique, dans lequel le dispositif d'entrée numérique (2) est opérationnel en utilisant une tension dans une plage de tensions admissibles, dans lequel la tension entraîne le courant électrique dans la ligne électrique (8), dans lequel la plage de tensions admissibles est limitée par une tension maximum à laquelle un premier courant électrique s'écoule dans la ligne électrique (8) et dans lequel le dispositif d'entrée numérique (2) comprend :
- une unité de génération de signal (6, 45) qui est adaptée pour produire le signal numérique représentant l'état de fonctionnement ;
**caractérisé par**
- une unité de commande (42) qui est adaptée pour commander la taille du courant électrique, dans lequel la ligne électrique (8) s'étend à l'intérieur de l'unité de commande (42),
dans lequel l'unité de commande (42) est adaptée pour empêcher des contacts du commutateur (5) d'être affectés par des débris ou une oxydation - si la tension est inférieure à la tension maximum - en commandant le courant électrique dans la ligne (8) de sorte que le courant électrique soit supérieur au premier courant électrique.

2. Dispositif d'entrée numérique selon la revendication précédente, dans lequel l'unité de génération de signal (6) et l'unité de commande (42) sont intégrées dans un module unique.

3. Dispositif d'entrée numérique selon la revendication précédente, dans lequel le module unique comprend des contacts externes joints (A, B) pour connecter électriquement l'unité de génération de signal (6, 45) et l'unité de commande (42) à d'autres parties ou composants.

4. Dispositif d'entrée numérique selon une des revendications précédentes, dans lequel le dispositif d'entrée numérique comprend une résistance (13) dans la ligne électrique (8) de sorte que l'énergie électrique se dissipe en chaleur.

5. Dispositif d'entrée numérique selon une des revendications précédentes, dans lequel l'unité de commande (7, 9, 10, 11, 13, 15) comprend un transistor (7) qui est commandé pour régler le courant électrique transporté par la ligne électrique (8) suivant la tension.

6. Dispositif d'entrée numérique selon la revendication précédente, dans lequel le transistor (7) est connecté en série à l'unité de génération de signal (6).

7. Dispositif d'entrée numérique selon la revendication 6, dans lequel le transistor est connecté en parallèle à un comparateur (45) pour comparer la tension à une tension de seuil.

8. Dispositif d'entrée numérique selon une des revendications précédentes, dans lequel l'unité de commande (7, 9, 10, 11, 13, 15) comprend une circuiterie de commande (11) qui comprend des contacts (E, F) destinés à être mis en contact avec une source de tension (1), dans lequel la source de tension (1) produit la tension (U) qui entraîne le courant électrique et dans lequel la circuiterie de commande (11) est adaptée pour produire un signal de commande (I1, I2) qui fait en sorte que la taille du courant électrique est augmentée si le courant est entraîné par une tension plus faible et vice versa.

9. Dispositif d'entrée numérique selon la revendication précédente, dans lequel la circuiterie de commande (11) comprend au moins un élément de commande (27, 28) qui est adapté pour augmenter linéairement la taille du courant électrique lorsque le courant électrique est entrainé par une tension réduite linéairement et vice versa.

10. Dispositif d'entrée numérique selon la revendication précédente, dans lequel la circuiterie de commande (11) comprend deux, ou plus, des éléments de commande (27, 28), dans lequel chacun des éléments de commande (27, 28) est adapté pour produire un signal de commande différent pour commander la taille du courant électrique et dans lequel l'unité de commande (7, 9, 10, 11, 13, 15) est adaptée pour utiliser un signal sélectionné des signaux de commande suivant la plage de la tension.

11. Agencement comprenant le dispositif d'entrée numérique (2) selon une des revendications précédentes et comprenant en outre le commutateur (5) pour allumer et éteindre la ligne électrique (8).

12. Procédé de produire un signal numérique, dans lequel le signal numérique est produit suivant un résultat de détection indiquant si un commutateur (5) dans une ligne électrique (8) est fermé - et donc un courant électrique est transporté par la ligne - ou si le commutateur est ouvert, détectant ainsi un état de fonctionnement d'un système ou composant (5), en particulier d'un composant électrique ou électronique, dans lequel la ligne électrique (8) est opérationnelle en utilisant une tension dans une plage de tensions admissibles, dans lequel la tension entraîne le courant électrique dans la ligne électrique (8), dans lequel la plage de tensions admissibles est limitée par une tension maximum à laquelle un premier courant électrique s'écoule dans la ligne électrique (8) et dans lequel le procédé comprend l'étape consistant à :
- produire un signal numérique représentant l'état de fonctionnement ; **caractérisé par** l'étape consistant à :
- empêcher des contacts du commutateur (5) d'être affectés par des débris ou une oxydation - si la tension est inférieure à la tension maximum - en commandant le courant électrique dans la ligne électrique (8) de sorte que le courant électrique soit supérieur au premier courant électrique.

13. Procédé selon la revendication 12, dans lequel le courant électrique est commandé en commandant un transistor (7) dans la ligne électrique (8) transportant le courant.

14. Procédé selon la revendication 12 ou 13, dans lequel la taille du courant électrique est augmentée linéairement lorsque le courant électrique est entraîné par une tension réduite linéairement et vice versa.

15. Procédé selon la revendication 14, dans lequel la taille du courant électrique est réduite linéairement selon une première fonction linéaire (I1) lorsque le courant électrique est entraîné par une tension augmentée linéairement et vice versa dans une première plage de la tension, dans lequel la taille du courant électrique est réduite linéairement selon une seconde fonction linéaire (I2) lorsque le courant électrique est entraîné par une tension augmentée linéairement et vice versa dans une seconde plage de la tension, et dans lequel la première fonction linéaire (I1) et la seconde fonction linéaire (I2) comprennent des pentes différentes et des décalages différents à la tension nulle, se rapprochant ainsi d'une réduction hyperbolique du courant électrique avec une tension de plus en plus importante.
